# EUROPEAN PATENT APPLICATION

(11) **EP 4 376 091 A1**
(43) Date of publication of application: **29.05.2024**
(21) Application number: 22209432.8
(22) Date of filing: 24.11.2022
(51) Int. Cl.: H01L 29/41, H01L 29/423, H01L 21/336, H01L 29/78

(54) **MOSFET FORMATION**

(71) Applicant: Nexperia B.V., 6534 AB Nijmegen (NL)
(72) Inventor: Efthymiou, Epameinondas, Manchester (GB); Kim, Hungjin, Shanghai (CN); Cousins, Ian, Manchester (GB); Madaras, Milan, Newport (GB); Kent, David, Newport (GB)
(74) Representative: Pjanovic, Ilija

(57) **Abstract**

A method of forming a gate of a split-gate trench MOSFET in an epitaxial layer, the epitaxial layer comprising a source polysilicon rib which extends generally perpendicularly to a plane of the epitaxial layer; wherein the method comprises providing trenches on either side of an upper portion of the source polysilicon rib, with inner walls of the trenches being formed by a deposited insulator, providing mask material which extends into the trench, providing photoresist on the epitaxial layer and using photolithography to pattern the photoresist, using the patterned photoresist to selectively etch the insulator, a portion of the insulator which is in contact with the source polysilicon being protected from etching by the mask material, removing the mask material and thereby forming trenches on either side of the source polysilicon, each trench having an inner wall formed by insulator which was protected from etching by the mask material, providing an insulator on the epitaxial layer, and providing a bar of gate polysilicon in each trench.

## Description

### FIELD

The present disclosure relates to a method of forming a gate of a split-gate trench MOSFET, and to a split-gate trench MOSFET.

### BACKGROUND

Metal-silicon dioxide-semiconductor field-effect transistors (MOSFETs) are widely known and are used in many applications. In a trench MOSFET, current is conducted vertically from one surface of the MOSFET (Drain) to the other surface (Source). The trench MOSFET may comprise an array of cells, each of which contains gate, source and drain. The cells are configured to conduct current in parallel, thereby providing a low on-state resistance.

A problem which may arise when fabricating a split gate trench MOSFET is that thermally growing a silicon dioxide layer as an inter poly oxide (IPO) may cause bowing of Si wafers. The problem becomes more severe for high voltage MOSFETS (>100V) where deep trenches and thick oxide liners are utilised.

It is an object of the present invention to overcome or mitigate a problem associated with the prior art.

### SUMMARY

According to a first aspect of the present invention, there is provided a method of forming a gate of a split-gate trench MOSFET in an epitaxial layer, the epitaxial layer comprising a source polysilicon rib which extends generally perpendicularly to a plane of the epitaxial layer; wherein the method comprises providing trenches on either side of an upper portion of the source polysilicon rib, with inner walls of the trenches being formed by a deposited insulator, providing mask material which extends into the trench, providing photoresist on the epitaxial layer and using photolithography to pattern the photoresist, using the patterned photoresist to selectively etch the insulator, a portion of the insulator which is in contact with the source polysilicon being protected from etching by the mask material, removing the mask material and thereby forming trenches on either side of the source polysilicon, each trench having an inner wall formed by insulator which was protected from etching by the mask material, providing an insulator on the epitaxial layer, and providing a bar of gate polysilicon in each trench.

Advantageously, the method provides a split-gate trench MOSFET without significant risk of thermal bowing occurring.

Each bar of gate polysilicon may include a step in its bottom surface.

The insulator may be etched to a depth of up to 3 microns. The insulator may be etched to a depth of up to 2 microns.

The insulator may be etched to a depth of at least 0.7 microns.

The insulator provided between the gate polysilicon and the epitaxial layer may be thermally grown.

The insulator between the gate polysilicon and the epitaxial layer may have a thickness of 1000A or less.

The insulator may be silicon dioxide. The mask material may be silicon nitride.

According to a second aspect of the invention there is provided a split-gate trench MOSFET comprising a pair of gates formed according to the first aspect of the invention.

According to a third aspect of the invention there is provided a split-gate trench MOSFET comprising an epitaxial layer having a source polysilicon rib which extends generally perpendicularly to a plane of the epitaxial layer, and further comprising bars of gate polysilicon provided either side of an upper end of the source polysilicon rib, wherein an insulator provided between the gate polysilicon and the source polysilicon is deposited, and wherein an insulator between gate polysilicon and the epitaxial layer is thermally grown.

Advantageously, split-gate trench MOSFET may be less liable to suffer from thermal bowing than conventionally formed split-gate trench MOSFETs.

Each bar of gate polysilicon may include a step in its bottom surface, the gate polysilicon stepping downwards in the direction of the source polysilicon.

Each bar of gate polysilicon may have a depth of up to 3 microns. Each bar of gate polysilicon may have a depth of up to 2 microns.

Each bar of gate polysilicon may have a depth of at least 0.7 microns.

Silicon dioxide present between each bar of gate polysilicon and the epitaxial layer may have a thickness of 800A or less.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 schematically depicts a cross section of a Si epitaxial layer of which is provided with an array of structures;
- Figures 2 to 12 schematically depict a method of forming a gate of a split-gate trench MOSFET according to a first embodiment;
- Figures 13 to 18 schematically depict a method of forming a gate of a split-gate trench MOSFET according to a second embodiment;
- Figures 19 to 31 schematically depict a method of forming a gate of a split-gate trench MOSFET according to a third embodiment;
- Figures 32 to 43 schematically depict a method of forming a gate of a split-gate trench MOSFET according to a fourth embodiment; and
- Figures 44 to 48 schematically depict a method of forming a gate of a split-gate trench MOSFET according to a fifth embodiment;

### DETAILED DESCRIPTION

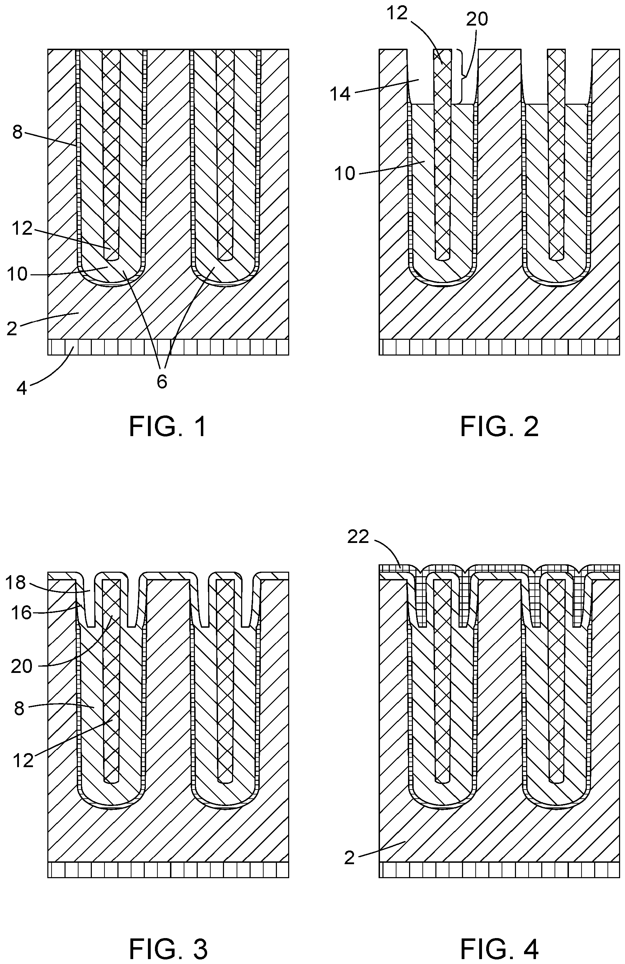

Figure 1 schematically depicts in cross-section part of an epitaxial layer 2 which is provided with an array of structures. The epitaxial layer 2 is provided on a substrate 4. For ease of illustration only a small thickness of the substrate 4 is depicted, although in practice the substrate is significantly thicker than the epitaxial layer 2. The substrate 4 is heavily doped in order to form a drain connection.

A series of trenches 6 is provided in the epitaxial layer 2. The trenches 6 may be elongate, extending out of the plane of the Figure 1. The trenches 6 extend downwardly from an upper surface of the epitaxial layer 2 towards the substrate 4, but do not extend into the actual substrate itself. The trenches 6 may have a depth of a few microns, depending on a voltage (VDS) rating (i.e. 30V-100V). For example, the trenches 6 may have a depth of e.g. around 9 microns. The trenches 6 may for example have a depth of at least 6 microns, and may have a depth of up to 12 microns.

A silicon dioxide liner 8 is provided on an inner wall of each trench 6 of the epitaxial layer 2. The silicon dioxide liner 8 may be thermally grown onto the epitaxial layer 2. The silicon dioxide liner 8, which may be referred to as a layer of silicon dioxide, may for example have a thickness of around 500 to 1000 angstroms. The thermally grown silicon dioxide liner 8 may provide a higher quality interface with the epitaxial layer 2 than deposited silicon dioxide. The silicon dioxide acts as an insulator.

An additional silicon dioxide layer 10 is provided on the thermally grown silicon dioxide liner 8. This additional silicon dioxide layer 10 is relatively thick, e.g. having a thickness of up to 0.8um for a VDS rating ~ 150V. The additional silicon dioxide layer 10 may be formed using sub-atmospheric chemical vapour deposition (SACVD) of tetraethylorthosilicate (TEOS) (or some other form of deposition).

Polysilicon deposition (e.g. using CVD) is used to provide polysilicon 12 in the form of ribs which extend downwards into the epitaxial layer 2 in each trench 6.

In addition to forming ribs, when it is deposited, the deposited polysilicon 12 forms a layer on top of the epitaxial layer 2 (the layer being formed as a side-effect of ensuring that the trenches are completely filled with polysilicon). An upper surface of the epitaxial layer 2 has undergone processing, e.g. chemical mechanical polishing (CMP) with end-point detection to remove the polysilicon layer. The CMP detects when silicon dioxide is exposed and then stops automatically. This provides a flat uppermost surface in which the tops of the polysilicon ribs 12, the tops of the silicon dioxide layers 8, 10 and the top of the epitaxial layer 2 are exposed. Forming the structure depicted in Figure 1 may be achieved using a conventional method, and does not form part of the invention.

Figures 2 - 12 illustrate a method, according to an embodiment, of forming gates of a split-gate trench MOSFET (metal-silicon dioxide-semiconductor field-effect transistor). For ease of description, at times in the following description only a single gate of the split-gate trench MOSFET is described (both in connection with this embodiment and with other embodiments). In practice, as illustrated, the split-gate trench MOSFET may comprise a series of trenches, each of which is provided with a pair of gates. For brevity, the split-gate trench MOSFET may be referred to as trench MOSFET or a MOSFET.

Referring to Figure 2, a liquid etch which selectively removes silicon dioxide but does not remove polysilicon or silicon is used. The etch may be referred to as a blanket wet etch, and may for example use buffered silicon dioxide etchant (BOE) or hydrofluoric acid (HF). The etch may be performed for a period of time which provides a desired gate trench depth. As depicted, the polysilicon rib 12 is not etched, and as a result an upper portion 20 of the polysilicon rib 12 is exposed and projects upwardly from the silicon dioxide 10. A trench 14 is formed in the silicon dioxide 10 either side of the polysilicon rib 12.

Referring to Figure 3, silicon dioxide is deposited onto the epitaxial layer 2 for example using chemical vapour deposition (e.g. sub-atmospheric SACVD) of TEOS (or a different deposition method). This forms a silicon dioxide layer 16 with a thickness of around 3,000A. Densification of the TEOS is also performed. The thickness of the silicon dioxide layer that is provided may be selected based upon a voltage to be handled between the gate and source of the trench MOSFET. A thickness of 3,000A of inter poly oxide (IPO) may be sufficient for a trench MOSEFET capable of handling at least 20V of gate-source voltage. A thinner silicon dioxide layer may be provided for example for a trench MOSFET configured to handle a lower gate-source voltage rating.

The silicon dioxide layer 16 is sufficiently thin that it does not fill the trenches 14. Instead, trenches 18 are present with walls of the trenches being formed by the silicon dioxide 16. The silicon dioxide layer 16 and the trenches 18 extend along either side the upper portion 20 of the polysilicon rib 12.

Referring to Figure 4, a layer of silicon nitride 22 is deposited onto the epitaxial layer 2 using low pressure chemical vapour deposition (LPCVD). For brevity, at times the silicon nitride may be referred to as nitride. The nitride 22 fills the trenches 18 in the silicon dioxide 16. In addition, the nitride 22 forms a layer on top of the epitaxial layer 2. The nitride layer 22 may for example have a thickness of around 2,000A. The thickness of the nitride layer 22 on the epitaxial layer is a side-effect of ensuring that the trenches 18 are completely filled with nitride. That is, in order to ensure that the trenches 18 are completely filled with nitride, nitride may be deposited which provides a thickness of around 2,000A on the epitaxial layer.

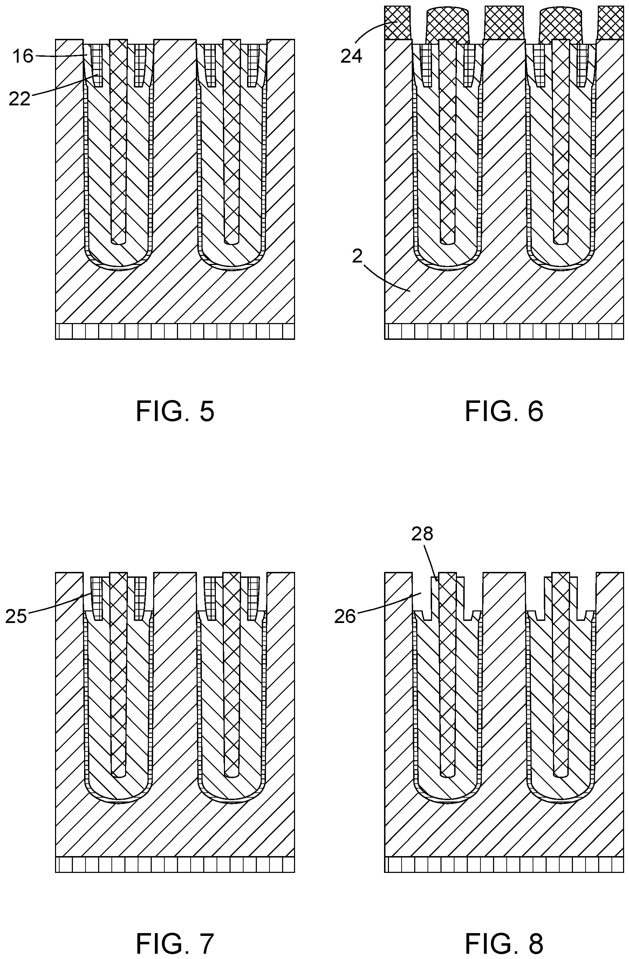

Referring to Figure 5, two etches are performed. The first is a nitride selective etch, which removes some nitride 22 from the epitaxial layer 2. The etch is performed for a period of time which is sufficient to etch the nitride below an upper surface of the epitaxial layer 2. The etch may for example remove nitride 22 to a depth of 0.05 microns or more below the upper surface of the epitaxial layer 2. The etch may remove nitride to a depth of up to 0.2 microns or up to 0.3 microns below the upper surface of the epitaxial layer 2. The etch may for example be a dry etch selective for nitride (e.g. a plasma etch).

The second etch is used to remove some silicon dioxide 16. Again, the etch is performed for a duration of time which is sufficient to etch the silicon dioxide 16 below the upper surface of the epitaxial layer 2. The etch may for example remove silicon dioxide 16 to a depth of 0.05 microns or more below the upper surface of the epitaxial layer 2. The etch may remove silicon dioxide to a depth of up to 0.2 microns or up to 0.3 microns. It is desirable that after the etch there is no nitride and no silicon dioxide on the upper surface of the epitaxial layer 2. The etch may for example be a dry etch selective for silicon dioxide (e.g. a plasma etch).

The etches are selected to the nitride and the silicon dioxide respectively, and thus do not etch the epitaxial layer 2 or the polysilicon rib 12. Consequently, an upper end of the polysilicon rib 12 projects from the silicon dioxide 16 (and the nitride 22).

Referring to Figure 6, a photoresist 24 is provided on the epitaxial layer 2. A lithographic projection system is used to expose a pattern in the photoresist 24. The pattern is aligned with the polysilicon rib structure formed in the epitaxial layer 2.

The photoresist is developed and exposed resist is removed, leaving behind the unexposed resist. As a result, a pattern of photoresist 24 remains on the epitaxial layer 2, as depicted in Figure 6.

Referring to Figure 7, a wet etch is then performed. The wet etch may for example be a buffered silicon dioxide etch. The wet etch does not remove material which is covered by the photoresist 24, because the photoresist is resistant to the wet etch. Instead, the wet etch removes silicon dioxide which is not covered by the photoresist 24. The epitaxial layer 2 and the nitride 22 are resistant to the wet etch and thus are not removed by the wet etch. The wet etch may be timed such that the silicon dioxide 16 is removed to a depth which is less than the depth to which the nitride 22 extends. In other words, the etch does not reach the bottom of the nitride 22. The photoresist is then removed, e.g. by dissolving it using a chemical process. As depicted in Figure 7, trenches 25 are formed. An inner wall of each trench 25 is provided by the nitride 22 and an outer wall of each trench is provided by the epitaxial layer 2.

The silicon dioxide 16 which is inward of the nitride 22 is not removed by the wet etch. This is because that silicon dioxide 16 is protected at its upper surface by the photoresist 24, and is protected on its side surface by the nitride 22.

Referring to Figure 8, the nitride is removed using a wet removal process. The wet removal process may for example use phosphoric acid. As a result, trenches 26 are formed. Each trench has an inner wall 28 which is formed by silicon dioxide 16 and has an outer wall which is formed by the epitaxial layer 2. Trenches 26 are present on either side of the upper portion of the polysilicon rib 12.

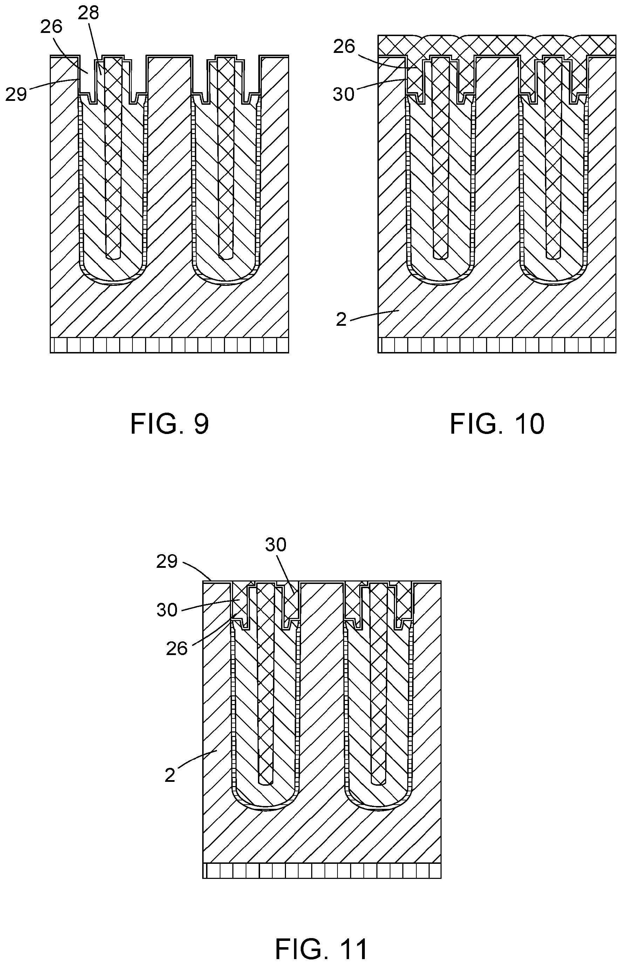

Referring to Figure 9, a thermal process is used to grow a liner (or layer) of silicon dioxide 29 in the trenches 26 (and also on the upper surface of the epitaxial layer 2). The silicon dioxide layer 29 may be for example around 600A thick. The silicon dioxide layer preferentially grows on the epitaxial layer, and does not grow to a significant extent upon the silicon dioxide 16 which is already present. Once this silicon dioxide layer 29 has been provided, each trench 26 has an outer wall of thermally grown silicon dioxide which has a thickness of the order of hundreds of angstroms. Each trench 26 has an inner wall of deposited silicon dioxide 28 which has a thickness of the order of thousands of angstroms.

Referring to Figure 10, polysilicon 30 is deposited onto the epitaxial layer 2. Polysilicon may be deposited using CVD. The polysilicon 30 may be deposited with a thickness of around 8000A. The polysilicon 30 fills each trench 26 and thereby forms a bar of polysilicon in each trench. The polysilicon 30 also forms a layer on the top surface of the epitaxial layer 2. As with other material layers, the thickness of polysilicon 30 on top of the epitaxial layer 2 is a side-effect of ensuring that the trenches 26 are filled with polysilicon.

Referring to Figure 11, chemical mechanical polishing (CMP) is used to remove the layer of polysilicon 30 from the top of the epitaxial layer 2. The CMP is stopped at the thermally grown layer of silicon dioxide 29 on the top of the epitaxial layer 2. Polysilicon 30 in the trench 26 remains.

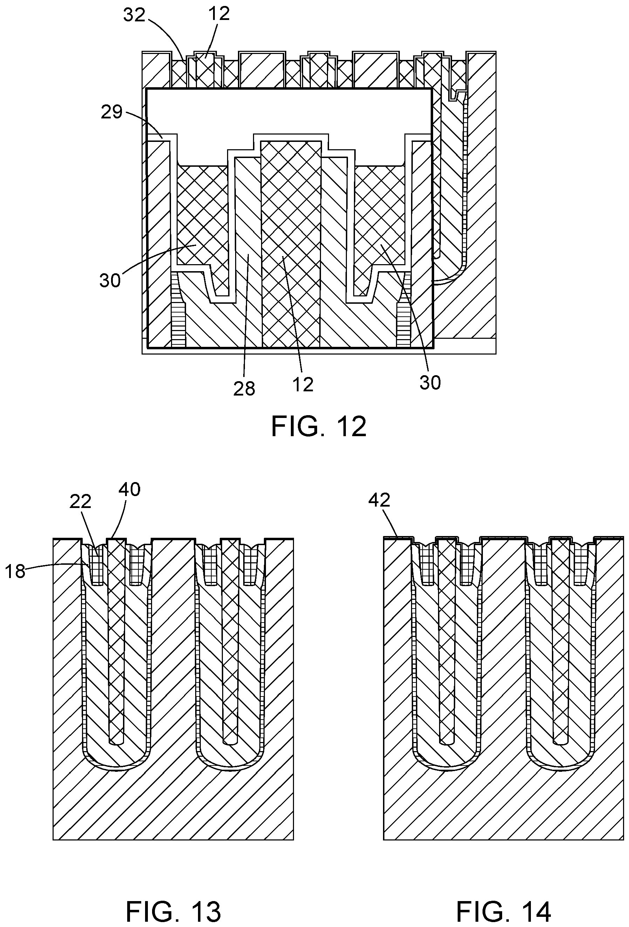

Referring to Figure 12, a dry etch of polysilicon which is selective to polysilicon is used to remove some polysilicon 30 in order to form a trench 32. The thermally grown layer of silicon dioxide 29 is not removed by the dry etch. An upper end of the polysilicon rib 12 projects from the trench 32.

Bars of polysilicon 30 are present on either side of the rib of polysilicon 12. The bars of polysilicon 30 are separated from the ribs of polysilicon by deposited silicon dioxide 28. The bars of polysilicon 30 form the gate polysilicon of the MOSFET.

P-type doping is provided in the epitaxial later 2 to a depth which generally corresponds with the depth of the gate polysilicon 30 (on an outer side of the gate polysilicon). The depth of the p-type doping may be less than the depth of the gate polysilicon 30 in order to ensure that the gate polysilicon is able to provide switching along the full depth of the p-type doping. The p-type doping provides the body of the MOSFET.

The source of the MOSFET is provided by an electrical connection (not depicted) on an upper surface of the p-type doped volume. The rib of polysilicon 12 may be referred to as a source (or source poly), or may be referred to as a shield (or shield poly), of the MOSFET. The rib of polysilicon 12 may enhance a VDS rating of the MOSFET. The same configuration may apply for other embodiments.

The substrate 2 provides the drain of the MOSFET.

As noted further above, the thermally grown silicon dioxide 29 between the gate polysilicon 30, and the epitaxial layer 2 has a thickness of the order of hundreds of angstroms. This relatively thin layer of insulator is necessary to control the formation of the MOSFET channel. The deposited silicon dioxide (IPO) 28 between the gate polysilicon 3, and the source polysilicon 12 has a thickness of the order of thousands of angstroms.

A second embodiment of the invention is depicted in Figures 13-18. The first few steps of the second embodiment correspond with the steps described above in connection with the first embodiment. The etches performed in connection with Figure 5 may leave an indent in the nitride 22 (as depicted in Figure 13) or may leave a flat nitride surface (as depicted in Figure 5).

Referring to Figure 13, a silicon dioxide layer (or liner) 40 is grown using a thermal process. The thermal process may be referred to as a pattern dependent oxidation (PADOX), meaning that silicon dioxide is preferentially provided on the polysilicon rib 12 and the epitaxial layer 2, and is not provided on the nitride 22. The layer of silicon dioxide 40 may for example have a thickness of around 1,000A.

Referring to Figure 14, an additional nitride layer 42 is deposited onto the substrate using low pressure chemical vapour deposition (LPCVD). The nitride layer 42 extends across the top of the epitaxial layer 2. The nitride layer 42 may for example have a thickness of around 2,000A on the top of the epitaxial layer.

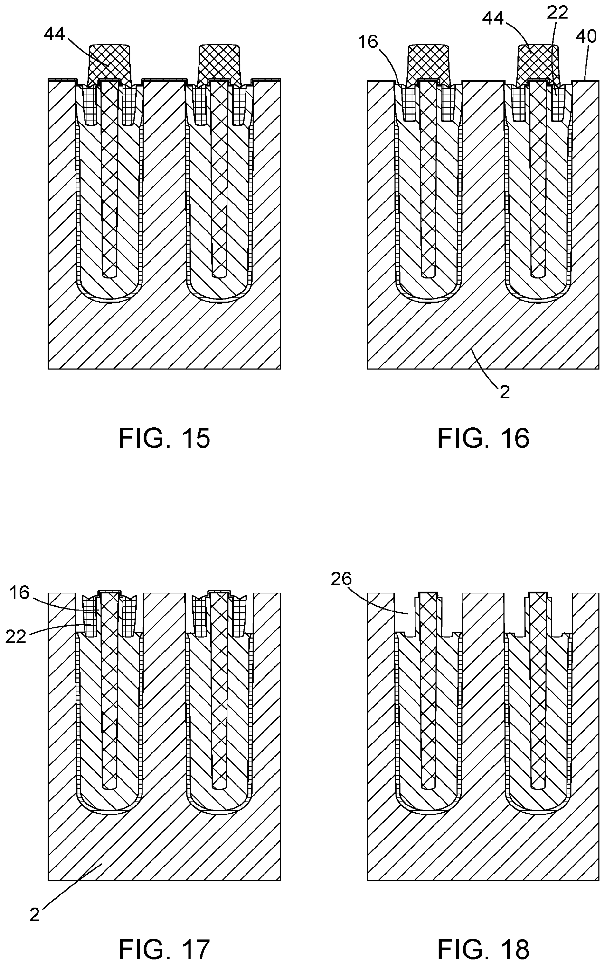

Referring to Figure 15, a photoresist 44 is provided on the nitride layer 42. A lithographic projection system is used to expose a pattern in the photoresist 44. The pattern is aligned with the polysilicon rib 12 structure formed in the epitaxial layer 2. The photoresist is developed. Exposed resist is then removed, leaving behind the unexposed resist. As a result, a pattern of photoresist 44 remains on the epitaxial layer 2, as depicted in Figure 15.

Referring to Figure 16, a nitride-selective dry etch is then performed. The dry etch may for example be a plasma etch. The dry etch does not remove nitride 22 which is covered by the photoresist 44 because the photoresist is resistant to the dry etch. As may be seen from Figure 16, the silicon dioxide layer 40 on top of the epitaxial layer 2 is once again exposed, and an upper end of the silicon dioxide 16 which is between the nitride 22 and the epitaxial layer 2 is exposed.

Referring to Figure 17, a wet etch is performed, for example using a buffered silicon dioxide etch. The epitaxial layer 2 and the nitride 22 are resistant to the wet etch and thus are not removed by the wet etch. The silicon dioxide 16 which is not covered by the nitride 22 is removed. The wet etch may be timed such that the silicon dioxide 16 is removed to a depth which is less than the depth to which the nitride 22 extends. In other words, the etch of the silicon dioxide 16 does not reach the bottom of the nitride 22. The etch may be to a depth of up to 2 microns. As may be seen, the silicon dioxide 16 which is inward of the nitride 22 is not removed by the wet etch. This is because the silicon dioxide is protected by the nitride 22.

Referring to Figure 18, the nitride is removed using a wet removal process. The wet removal process may for example use phosphoric acid. This result is a trench 26, which has the same form as the trench depicted in Figure 8.

Remaining steps of the second embodiment may be the same as the steps described further above for the first embodiment.

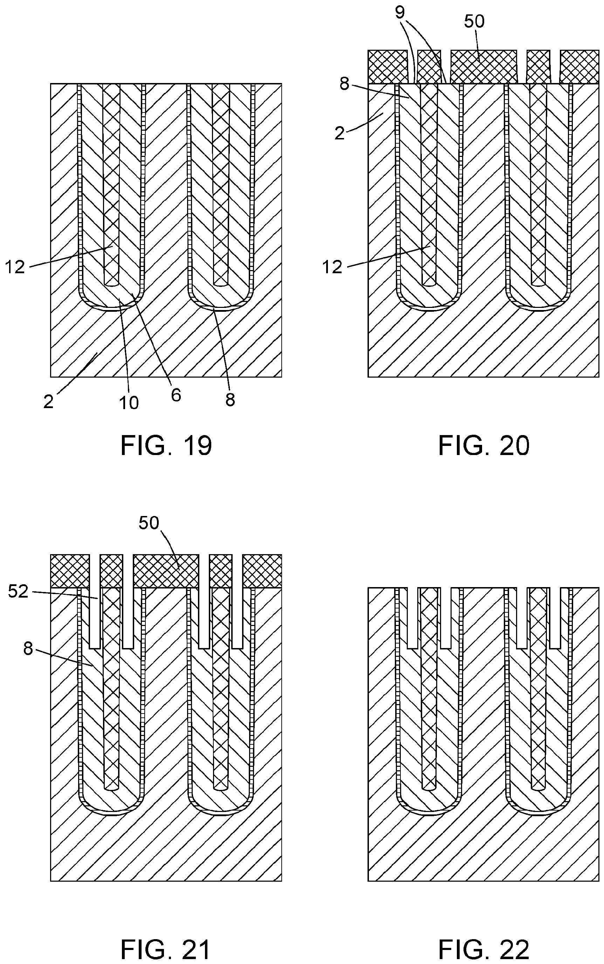

Figures 19 to 31 schematically depict a method according to a third embodiment. Figure 19 corresponds with Figure 1 of the first embodiment. The third embodiment differs from the first and second embodiments in that it does not include a blanket wet etch and the subsequent deposition of a silicon dioxide layer 16 with a thickness of around 3,000A into a trench 14 (see Figure 3). Instead, silicon dioxide 8 which is already present is used.

Referring to Figure 20, photoresist 50 is provided on the epitaxial layer 2. A lithographic projection system is used to expose a pattern in the photoresist 50. The pattern is aligned with the polysilicon rib 12 structure formed in epitaxial layer 2. The photoresist is then developed. Exposed resist is removed, leaving behind the unexposed resist. As a result, a pattern of photoresist 50 remains on the epitaxial layer 2, as depicted in Figure 20.

The pattern which is formed in the photoresist 50 covers the polysilicon ribs 12 and covers the exposed upper surface of the epitaxial layer 2. In addition, some of the silicon dioxide 8 is covered by the pattern. However, an upper surface of part of the silicon dioxide 8 is exposed. This exposed surface is part-way between the polysilicon rib 12 and the epitaxial layer 2. Referring to Figure 21, a dry plasma etch is used to etch the silicon dioxide 8. The etch is selective to the silicon dioxide 8 and does not remove the photoresist 50. As a result, a trench 52 is formed in the silicon dioxide 8. The trench 52 may for example have a depth of up to around 2 microns below the upper surface of the epitaxial layer 2.

Referring to Figure 22, the photoresist is then removed.

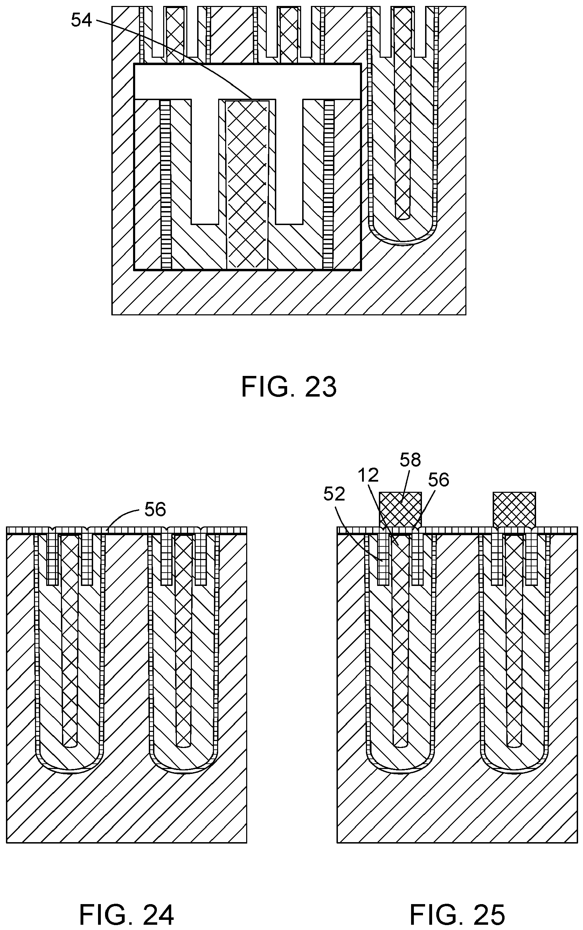

Referring to Figure 23, a silicon dioxide layer (liner) is thermally grown onto the epitaxial layer 2. The silicon dioxide layer 54 may for example have a thickness of around 600A.

Referring to Figure 24, a layer of nitride 56 is deposited onto the epitaxial layer 2. The nitride fills the trench 52 and forms a layer on top of the epitaxial layer 2. The nitride layer 56 may for example have a thickness of around 2,000A. A sufficient thickness of nitride 56 may be provided to ensure that the trenches 52 are completely filled with nitride.

Referring to Figure 25, photoresist is provided on the nitride layer 56 and is lithographically exposed then developed. The resulting pattern of photoresist 58 covers the nitride 56 which is located above the polysilicon rib 12, and covers part of the nitride which fills the trench 52. The remainder of the nitride 56 is not covered by the photoresist 58.

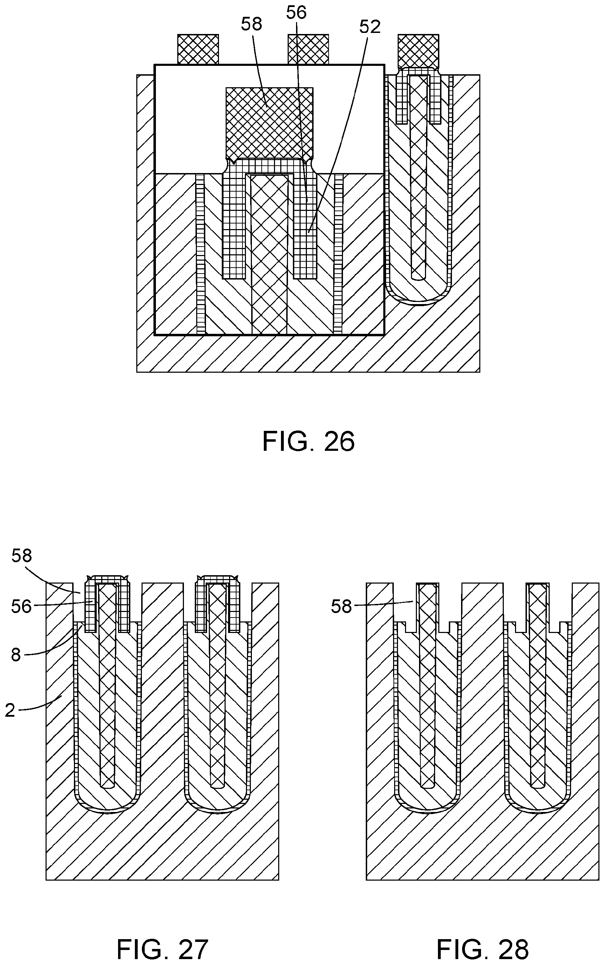

Referring to Figure 26, a nitride dry etch is performed which removes nitride which is not covered by the photoresist 58. The dry etch is performed for a sufficiently long period of time that the layer of nitride 56 which covers the epitaxial layer 2 is removed, but the nitride 56 in the trench 52 is not removed (or a significant amount of the nitride in the trench 52 remains).

Referring to Figure 27, the photoresist is removed and then a buffered silicon dioxide etchant (BOE) wet etch is performed to remove the silicon dioxide 8 which is between the nitride 56 and the epitaxial layer 2. The wet etch may be timed such that the silicon dioxide 8 is removed to a depth which is less than depth to which the nitride 56 extends. The etch may be to a depth of up to 2 microns. As depicted in Figure 27, a trench 58 is formed. An inner wall of the trench 58 is provided by the nitride 56 and an outer wall of the trench is provided by the epitaxial layer 2.

Referring to Figure 28, the nitride is removed using a wet removal process. As a result, the size of the trench 58 increases. An inner wall of the trench 58 is now provided by deposited silicon dioxide 8. The outer wall continues to be provided by the epitaxial layer 2.

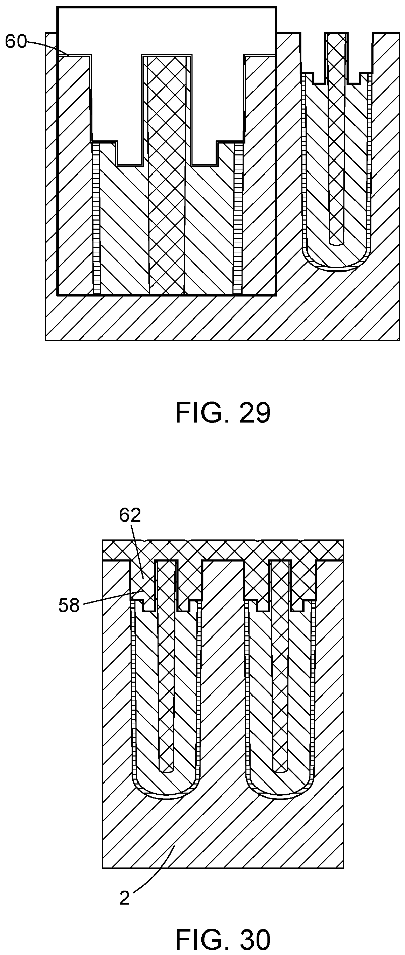

Referring to Figure 29, a silicon dioxide layer (liner) 60 is grown on the substrate. The silicon dioxide layer 60 is grown using a thermal process. The silicon dioxide layer 60 may for example be around 600A thick.

Referring to Figure 30, polysilicon 62 is deposited into the trench 58. The polysilicon 62 fills the trench 58 and forms a layer on top of the epitaxial layer 2.

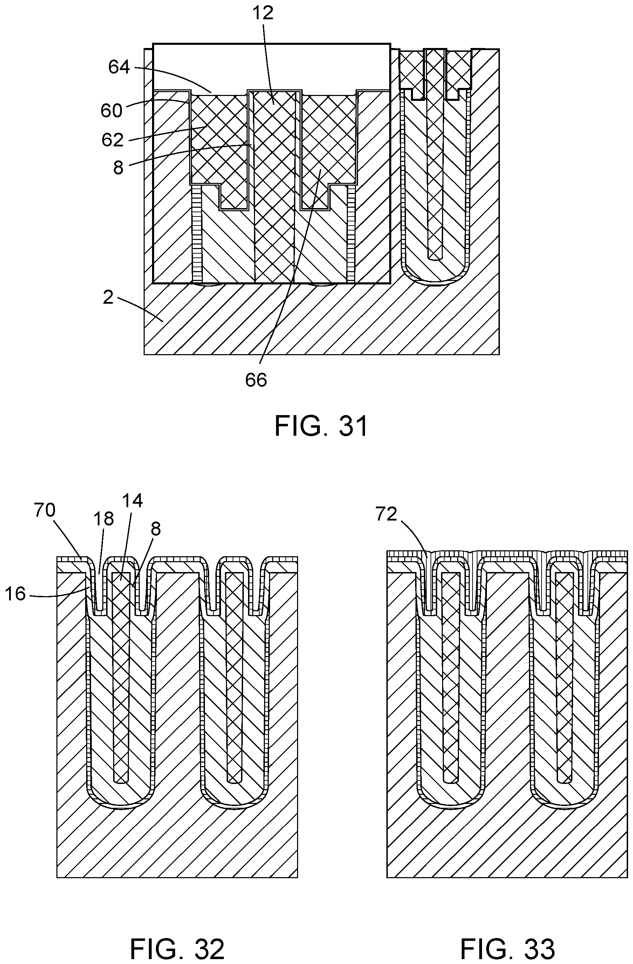

Referring to Figure 31, chemical mechanical polishing (CMP) is used to remove the layer of polysilicon from the top of the epitaxial layer 2. The CMP is stopped at the thermally grown layer of silicon dioxide 60 on top of the epitaxial layer 2. A wet etch which is selective to polysilicon is used to remove some polysilicon 62 in order to form a trench 64. The thermally grown layer of silicon dioxide 60 is not removed by the wet etch. An upper end of the polysilicon rib 12 projects as a mesa from the trench 64. The trench 64 which is formed in the polysilicon may have a depth of around 2,500A from the top of the mesa.

As with other embodiments, bars of polysilicon 66 form gates of a MOSFET. The rib of polysilicon 12 forms the source of the MOSFET. The drain is formed by the doped bottom layer of the epitaxial layer 2 (not shown in Figure 31). The bars of polysilicon 62 may be referred to as gate polysilicon 62. The polysilicon rib 12 may be referred to as source (or shield) polysilicon 12. The thermally grown silicon dioxide 60 between the gate polysilicon 62 and the epitaxial layer 2 has a thickness of the order of hundreds of angstroms. The deposited silicon dioxide 8 between the gate polysilicon 66 and the source polysilicon 12 has a thickness of the order of thousands of angstroms.

A fourth embodiment of the invention is schematically depicted in connection with Figures 32-43. The method according to the fourth embodiment commences from the step described further above in connection with Figure 3 of the first embodiment. That is, an epitaxial layer 2 has been provided with a series of polysilicon ribs 12 which are surrounded by silicon dioxide 8. For each polysilicon rib 12, a trench has been formed on either side of an upper end of the polysilicon rib. The trench has been partially filled with silicon dioxide 16 such that a narrower trench 18 remains. Referring to Figure 32, nitride deposition is used to form a layer of nitride 70 on the epitaxial layer 2. The layer of nitride 70 covers the silicon dioxide 16 in the trench 18 such that an inner wall of the trench 18 is formed by the nitride 70. The thickness of the nitride 70 is not sufficient to fill the trench 18.

Referring to Figure 33, a bottom anti-reflective coating (BARC) 72 is provided on the substrate. The BARC 72 fills the trench 18 and also forms a layer on top of the epitaxial layer 2.

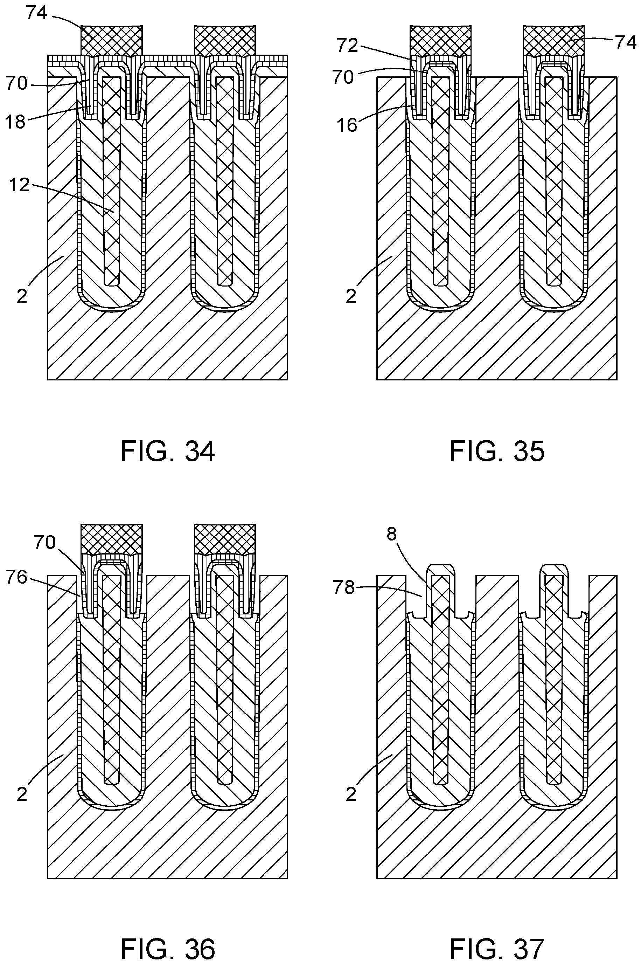

Referring to Figure 34, photoresist is provided on the epitaxial layer 2 and is patterned using lithography aligned to the polysilicon ribs 12. This provides patterned resist 74 which covers the polysilicon rib 12 and also covers the trench 18 (including the nitride 70 outer wall of the trench).

Referring to Figure 35, a dry etch is performed which removes BARC, nitride and silicon dioxide. As depicted, this exposes an upper surface of the epitaxial layer 2. The nitride 70 and BARC 72 which are located beneath the exposed photoresist 74 are protected from the etch and are not removed.

Referring to Figure 36, a BOE wet etch is used to remove silicon dioxide. The silicon dioxide which is removed is silicon dioxide 16 which is outward of the nitride 70. As with other embodiments, the etch is timed such that it does not extend fully to the bottom of the nitride 70. The etch may be to a depth of up to 2 microns. As depicted in Figure 36, a trench 76 is formed. An inner wall of the trench 76 is provided by the nitride 70 and an outer wall of the trench is provided by the epitaxial layer 2.

Referring to Figure 37, the resist, BARC and nitride are removed using a dry etch or multiple different etches. This forms a trench 78. The trench 78 has an inner wall which is formed by silicon dioxide 8, and an outer wall which is formed by the epitaxial layer 2.

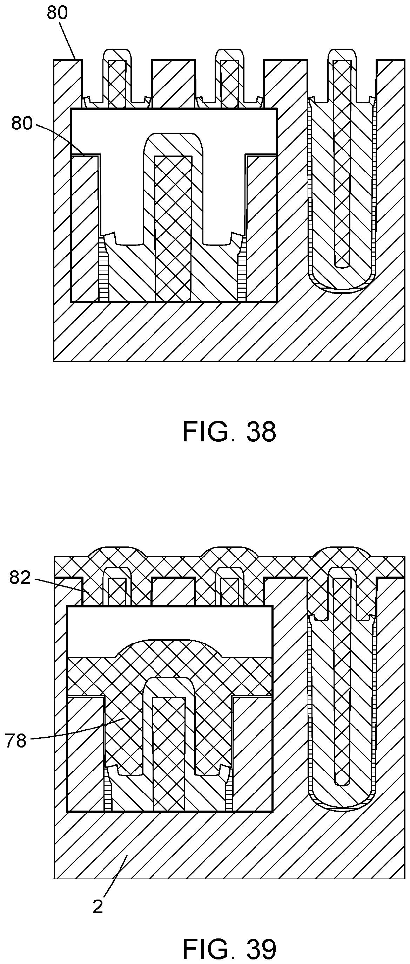

Referring to Figure 38, a layer (liner) of silicon dioxide 80 is thermally grown on the substrate. The layer 80 of silicon dioxide may for example have a thickness of around 600A.

Referring to Figure 39, gate polysilicon 82 is deposited onto the epitaxial layer 2. The gate polysilicon 82 fills the trench 78 and also forms a layer on top of the epitaxial layer 2. The gate polysilicon 82 may be provided as a layer of around 8000A. The amount of gate polysilicon that is provided may be sufficient to ensure that the trench 78 is completely filled with polysilicon.

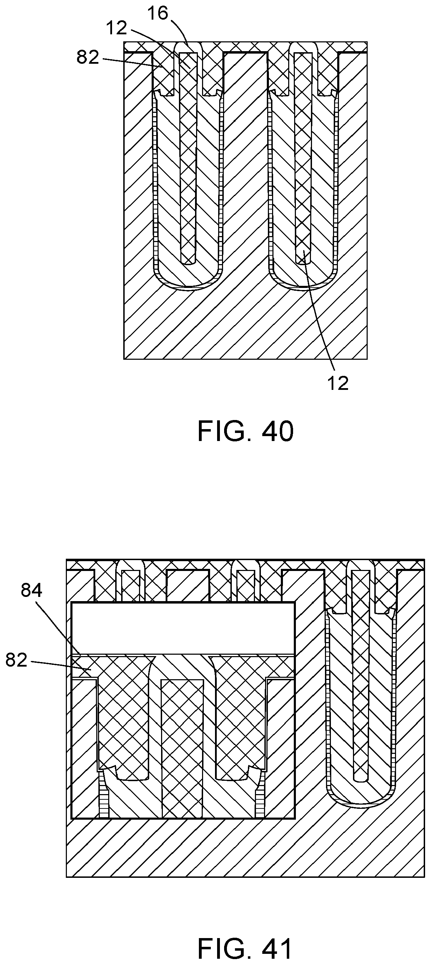

Referring to Figure 40, chemical mechanical polishing (CMP) is applied to the gate polysilicon 82, thereby removing the gate polysilicon 82, until an uppermost surface of the silicon dioxide 16 on top of the polysilicon rib 12 is reached.

Referring to Figure 41, a silicon dioxide layer 84 is thermally grown on top of the gate polysilicon.

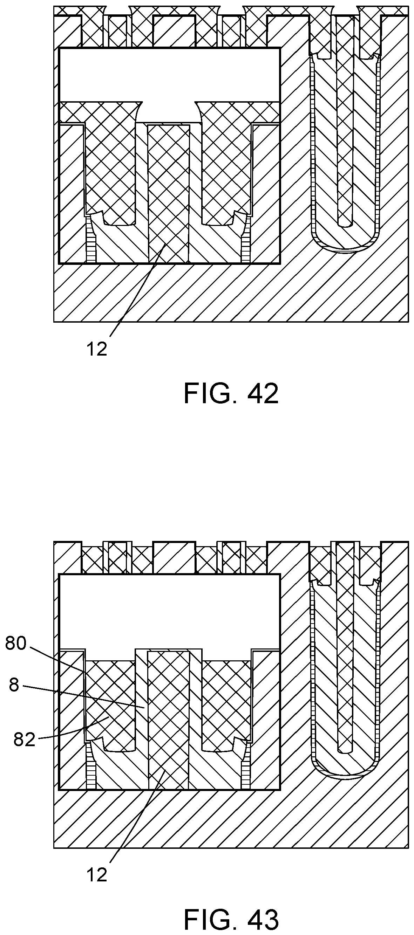

Referring to Figure 42, an etch is used to remove the thermally grown silicon dioxide layer 84, and to etch into the silicon dioxide which is above the polysilicon rib 12.

Referring to Figure 43, a polysilicon selective etch is used to remove some of the gate polysilicon 82 such that the gate polysilicon 82 is trenched relative to an upper end of the source polysilicon 12.

As with other embodiments, bars of polysilicon 82 form gates of a split-gate trench MOSFET. The rib of polysilicon 12 forms a source (or shield) of the MOSFET. The drain is formed by the doped bottom layer 4 of the epitaxial layer 2 (not visible). The bars of polysilicon 82 may be referred to as gate polysilicon 82. The polysilicon rib 12 may be referred to as source polysilicon 12. The thermally grown silicon dioxide 80 between the gate polysilicon 82 and the epitaxial layer 2 has a thickness of the order of hundreds of angstroms. The deposited silicon dioxide 8 between the gate polysilicon 82 and the source polysilicon 12 has a thickness of the order of thousands of angstroms.

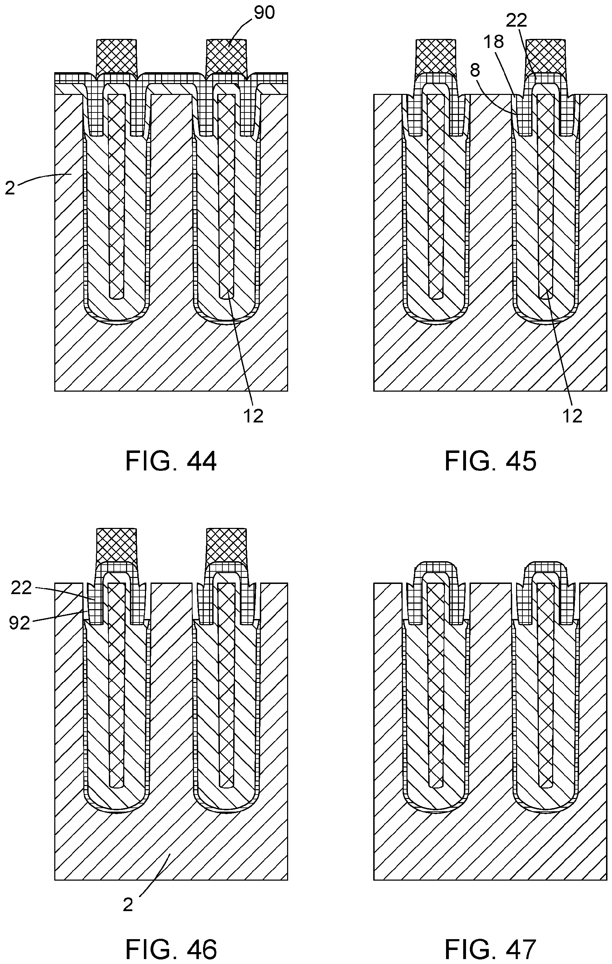

A fifth embodiment of the invention is depicted in Figures 44-48. The steps of the fifth embodiment up to Figure 44 are the same as those described further above in connection with Figures 1-4 of the first embodiment.

In Figure 44, photoresist 90 is provided on the epitaxial layer 2. A pattern is projected into the photoresist 90. As with other embodiments, the pattern is aligned with the polysilicon rib 12 structure formed in the epitaxial layer 2. The photoresist 90 is developed. Exposed photoresist is then removed, leaving behind the unexposed photoresist. As a result a pattern of photoresist 90 remains on the epitaxial layer 2, as depicted in Figure 44.

Referring to Figure 45, a nitride-selective dry etch is then performed. The dry etch does not remove nitride 22 which is covered by the photoresist 90 because the photoresist is resistant to the dry etch. The dry etch is performed for a sufficiently long period of time that the layer of nitride 22 which covers the epitaxial layer 2 is removed, but the nitride in the trench 18 is not removed (or a significant amount of the nitride in the trench 18 is not removed).

Referring to Figure 46, a BOE wet etch is performed to remove the silicon dioxide 8 which is between the nitride 22 and the epitaxial layer 2. The wet etch may be timed such that the silicon dioxide 8 is removed to a depth which is less than a depth to which the nitride 22 extends. The etch may be to a depth of up to 2 microns. As depicted in Figure 46, a trench 92 is formed. An inner wall of the trench 92 is provided by the nitride 22 and an outer wall of the trench is provided by the epitaxial layer 2.

Referring to Figure 47 the photoresist is removed.

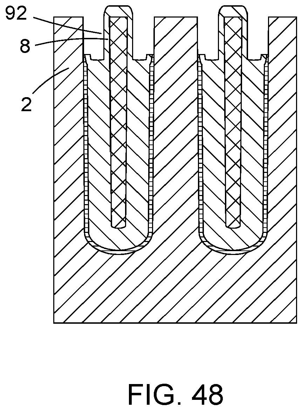

Referring to Figure 48, the nitride is removed using a wet removal process. As a result, the size of the trench 92 increases. An inner wall of the trench 92 is now provided by deposited silicon dioxide 8. The outer wall continues to be formed by the epitaxial layer 2.

The remaining steps of the fifth embodiment correspond with the steps described further above in connection with Figures 36-43 of the fourth embodiment.

In embodiments of the invention, gate polysilicon is provided as a bar which is separated by silicon dioxide from the source polysilicon. As noted further above, the maximum gate-source voltage that can be accommodated by the split-gate trench MOSFET depends in part upon the thickness of the silicon dioxide between the gate polysilicon and the source/shield polysilicon (thicker silicon dioxide prevents electrical conduction (breakdown) at higher voltages). The silicon dioxide between the gate polysilicon and the source polysilicon may have a thickness of at least 2,000A. The silicon dioxide between the gate polysilicon and the source polysilicon may have a thickness of at least 3,000A. A thickness of 3,000A may be sufficient for a trench MOSEFET capable of having a gate-source rating of 20V

In embodiments of the invention, thermally grown silicon dioxide between the gate polysilicon and the epitaxial layer may have a thickness of 800A or less. Silicon dioxide between the gate polysilicon and the epitaxial layer may have a thickness of at least 500A. The thickness of the silicon dioxide between the gate polysilicon and the epitaxial layer may determine the gate-source rating of the trench MOSFET.

In embodiments of the invention, the depth of the gate polysilicon 30 plays a key role in defining the channel length and the extent of the parasitic gate-drain capacitance. In this context depth means the vertical dimension of the gate polysilicon in the figures. A short channel length will provide a benefit to resistance (RDSon) of the MOSFET. However, if the channel is too short then his may lead to undesirable effect such as elevated drain-source leakage current.

The gate polysilicon 30 may for example have a depth of at least 0.7 microns (measured on an outer side of the gate polysilicon). If the gate polysilicon 30 were to have a depth of less than 0.7 microns then that could give rise to an unacceptable drain-source leakage current. The gate polysilicon 30 may for example have a depth of 0.8 microns or more. This depth may be desirable in order to ensure that the drain-source leakage current always remains below a desirable level.

The depth of the gate polysilicon 30 may for example be up to 3 microns. The depth of the gate polysilicon may for example be preferably up to 2 microns. As noted further above, P-type doping is provided in the epitaxial later 2 to a depth which generally corresponds with the depth of the gate polysilicon 30. The depth of the p-type doping may be less than the depth of the gate polysilicon 30 in order to ensure that the gate polysilicon is able to provide switching along the full depth of the p-type doping. However, if the depth of the p-type doping is significantly less than the depth of the gate polysilicon 30 then this may cause undesirable parasitic capacitance. For this reason, if it is expected that the P-type doping will extend to a depth of up to 2 microns, then the gate polysilicon 30 may be provided to a depth of 2 microns.

Although embodiments of the invention have been described in connection with silicon dioxide layers, other insulating materials may be used. Silicon dioxide is desirable because its properties are well known and it provides good insulation.

Embodiments of the invention use silicon nitride as a material which controls where etching occurs. In other words the silicon nitride provides etching selectivity. That is, the silicon nitride works as a mask which controls etching. Other mask materials may be used to provide etching selectivity. Silicon nitride is desirable because its properties are well known and it provides good etching selectivity.

In the described embodiments, photoresist which is not exposed during lithography remains on the surface and photoresist which is exposed is removed. In an alternative arrangement, photoresist which is exposed during lithography remains on the surface and photoresist which is not exposed is removed.

In this document, dimensions are provided merely as indicative examples, and are not intended to be limiting.

When describing etches in connection with some embodiments, the nature of the etch may not be fully described. Where this is the case, the nature of the etch may be assumed to be the same as an etch described for a different embodiment which removes the same material.

In embodiments of the invention, each bar of gate polysilicon includes a step in its bottom surface. The bar of gate polysilicon steps downwards in the direction of the source polysilicon. The step is present because the bar of gate polysilicon is formed using two etches. The first etch extends partway down but not fully down to the bottom of a nitride barrier (which protects silicon dioxide between the nitride and the source polysilicon). The second etch removes the nitride barrier. Prior art methods of forming trench MOSFET gates do not use this two-etch method. Therefore, the presence of the step indicates that a method according to an embodiment has been used.

## Claims

1. A method of forming a gate of a split-gate trench MOSFET in an epitaxial layer, the epitaxial layer comprising a source polysilicon rib which extends generally perpendicularly to a plane of the epitaxial layer; wherein the method comprises:
providing trenches on either side of an upper portion of the source polysilicon rib, with inner walls of the trenches being formed by a deposited insulator;
providing mask material which extends into the trench;
providing photoresist on the epitaxial layer and using photolithography to pattern the photoresist;
using the patterned photoresist to selectively etch the insulator, a portion of the insulator which is in contact with the source polysilicon being protected from etching by the mask material;
removing the mask material and thereby forming trenches on either side of the source polysilicon, each trench having an inner wall formed by insulator which was protected from etching by the mask material;
providing an insulator on the epitaxial layer; and
providing a bar of gate polysilicon in each trench.

2. The method of claim 1, wherein each bar of gate polysilicon includes a step in its bottom surface.

3. The method of any preceding claim, wherein the insulator is etched to a depth of up to 3 microns.

4. The method of any preceding claim, wherein the insulator is etched to a depth of at least 0.7 microns.

5. The method of any preceding claim, wherein the insulator provided between the gate polysilicon and the epitaxial layer is thermally grown.

6. The method of claim 5, wherein the insulator has a thickness of 1000A or less.

7. The method of any preceding claim, wherein the insulator is silicon dioxide and the mask material is silicon nitride.

8. A split-gate trench MOSFET comprising a pair of gates formed according to the method of any preceding claim.

9. A split-gate trench MOSFET comprising an epitaxial layer having a source polysilicon rib which extends generally perpendicularly to a plane of the epitaxial layer, and further comprising bars of gate polysilicon provided either side of an upper end of the source polysilicon rib, wherein an insulator provided between the gate polysilicon and the source polysilicon is deposited, and wherein an insulator between gate polysilicon and the epitaxial layer is thermally grown.

10. The split-gate trench MOSFET of claim 9, wherein each bar of gate polysilicon includes a step in its bottom surface, the gate polysilicon stepping downwards in the direction of the source polysilicon.

11. The split-gate trench MOSFET of claim 9 or claim 10, wherein each bar of gate polysilicon has a depth of up to 3 microns.

12. The split-gate trench MOSFET of any of claims 9 to 11, wherein each bar of gate polysilicon has a depth of at least 0.7 microns.

13. The split-gate trench MOSFET of any of claims 9 to 12, wherein silicon dioxide present between each bar of gate polysilicon and the epitaxial layer has a thickness of 800A or less.
